# EUROPÄISCHE PATENTANMELDUNG

(11) **EP 0 568 963 A2**
(43) Veröffentlichungstag der Anmeldung: **10.11.1993**
(21) Anmeldenummer: 93107177.3
(22) Anmeldetag: 03.05.1993
(51) Int. Cl.: H04N 5/655

(54) **Chassis für ein Fernsehsignalempfangsgerät**

(30) Priorität: 07.05.1992 DE 9206134 U
(71) Anmelder: SIEMENS AKTIENGESELLSCHAFT, D-80333 München (DE)
(72) Erfinder: Dangschat, rainer, Dipl.-Ing.(FH), W-8011 Landsham (DE)

(57) **Zusammenfassung**

Die Erfindung betrifft ein Chassis für ein Fernsehsignalempfangsgerät, das eine auf einer Hauptplatine (1) angeordnete Stromversorgungseinrichtung (2), einen Tuner (3), eine Steuereinrichtung (4) sowie eine eine zentrale Signalverarbeitung des Fernsehsignalempfangsgerätes übernehmende Einrichtung (5) aufweist. Diese Einrichtung ist auf einer Zentralplatine (6) angeordnet, die im Vergleich zur Hauptplatine (1) in ihrer Fläche kleiner und parallel zur Hauptplatine (1) über dieser angeordnet ist. Der Bereich der Hauptplatine (1), der sich unterhalb der Zentralplatine (6) befindet, ist mit einer Abschirmung (7) versehen.

Der wesentliche Vorteil eines solchen Chassis besteht in der Flexibilität hinsichtlich der zentralen Signalverarbeitung.

## Beschreibung

Die Erfindung betrifft ein Chassis für ein Fernsehsignalempfangsgerät, insbesondere für ein Farbfernsehgerät oder einen Videorekorder, wie es im Oberbegriff des Anspruchs 1 angegeben ist.

Chassis für solche Fernsehempfangsgeräte sind im allgemeinen in Modultechnik aufgebaut. So befinden sich beispielsweise bei einem Farbfernsehgerät auf einer Hauptplatine neben dem Netzteil, einem Videocontroller, einer Ablenkstufe, einem Audioverstärker und einer Steuereinrichtung in Form eines Mikrocontrollers auch Module für eine Einrichtung zur zentralen Signalverarbeitung, wie z.B. ein Tunermodul, ein Ton-ZF-Modul, ein Bild-ZF-Modul, ein Farbdecodermodul usw.. Diese Modultechnik sieht kleinere in SMD-(Surface-Mounted-Device)-Technik bestückte kleinere Platinen vor, die im allgemeinen vertikal zur Hauptplatine angeordnet sind. Durch eine derartige Modultechnik wird ein hohes Maß an Flexibilität in Chassis für Fernsehsignalempfangsgeräte erreicht.

Mittlerweile sind aber auch Chassis bekannt geworden, die auf der Hauptplatine als lösbares Modul lediglich noch ein Tunermodul aufweisen. Die übrigen Schaltungskomponenten sind dagegen mit der Hauptplatine fest verbunden. In zunehmendem Maße werden dabei integrierte Schaltungsanordnungen eingesetzt, die die gesamte zentrale Signalverarbeitung des Fernsehgerätes, wie z.B. Bild-ZF-Stufe, Ton-ZF-Stufe, Farbdecodierung, RGB-Stufe, H+V-Synchronisation sowie den Scart-Schalter beinhalten und lediglich noch mit wenigen Bauelementen extern beschaltet werden müssen.

Solche Chassis sind zwar kostengünstig herzustellen, bieten aber lediglich ein geringes Maß an Flexibilität hinsichtlich ihrer Einsatzmöglichkeiten. So ist z. B. bei der Produktion von Fernsehgeräten mit dem Einsetzen der Hauptplatine in das Fernsehgerät festgelegt, welche Norm das Fernsehgerät empfangen kann, sofern die Hauptplatine aus Kostengründen lediglich für den Empfang einer einzigen Norm ausgestattet ist. Darüberhinaus ist mit dem Einsetzen der Hauptplatine auch festgelegt, ob das Gerät Stereo- oder Monotonsignale empfangen kann, usw.

Zusätzlich haben solche Einplatinenchassis den Nachteil, daß beim Ausfall eines Bauelementes, z. B. bei der zentralen Signalverarbeitung, die komplette Hauptplatine aus dem Fernsehgerät ausgebaut werden muß.

Der vorliegenden Erfindung liegt deshalb die Aufgabe zugrunde, ein Chassis für ein Fernsehsignalempfangsgerät anzugeben, das die obengenannten Nachteile nicht aufweist.

Diese Aufgabe wird dadurch gelöst, daß bei einem Chassis der eingangs genannten Art die die zentrale Signalverarbeitung des Fernsehers übernehmende Einrichtung auf einer Zentralplatine angeordnet wird, daß diese Zentralplatine über der Hauptplatine parallel zu dieser montiert ist und daß der Bereich der Hauptplatine, der sich unterhalb der Zentralplatine befindet, mit einer Abschirmung versehen ist.

Weiterbildungen der Erfindung sind Gegenstand der Unteransprüche.

Es wird also vorgeschlagen, die zentrale Signalverarbeitung des Fernsehsignalempfangsgerätes, die beispielsweise die Stufen Bild-ZF, Ton-ZF, Farbdecodierung, RGB-Videoprozessor, H+V-Synchronisation und Scart-Schalter aufweist, auf einer parallel zur Hauptplatine liegenden und über dieser angeordneten Zentralplatine zu realisieren, vorzugsweise durch eine integrierte Schaltungsanordnung mit nur noch wenigen zusätzlichen externen Bauelementen.

Derartig integrierte Schaltungsanordnungen sind mittlerweile bekannt und verfügen meist über Pinzahlen zwischen 40 und 64 und werden mit SMD-Kondensatoren und Widerständen beschaltet. Dies ist vor allem deshalb notwendig, weil die sonst üblichen normalen axial und radial bedrahteten Bauelemente ungenügend HF-Eigenschaften aufweisen und bei den vorgeschriebenen Einstrahlprüfungen fast unlösbare Probleme verursachen. Auch die Störeinstrahlung innerhalb des Gerätes, z. B. vom Netzteil oder von der H-Ablenkung wird durch die Verwendung der SMD-Technik und optimale Masseverbindungen bei derartigen integrierten Schaltungsanordnungen deutlich verringert.

Gemäß der Erfindung ist es möglich, lediglich die Zentralplatine mit den darauf angeordneten Bauelementen in SMD-Technik zu realisieren, während die Hauptplatine wie üblich, mit Standard-Bauelementen in einseitiger Leiterplatten-Technik ausgeführt werden kann.

Gemäß der Erfindung wird die unterhalb der Zentralplatine liegende Hauptplatinenfläche mit einer Abschirmung versehen. Dies geschieht vorzugsweise durch die auf der Hauptplatinenfläche ohnehin vorhandene Kupferkaschierung, die zum Zwecke der Abschirmung unterhalb der Zentralplatine nicht oder im wesentlichen nicht weggeätzt wird, so daß eine gute Abschirmung erreicht wird. Diese Abschirmung in Form der Kupferkaschierung der Hauptplatine bewirkt auch eine optimale Masseverbindung. Auch Stromversorgungsleitungen können unterhalb des Moduls verlaufen und zur elektrischen optimalen Leitungsführung beitragen.

Die vorgeschlagene horizontal zur Hauptplatine angeordnete Zentralplatine hat gegenüber einem senkrecht zur Hauptplatine stehenden Modul folgende Vorteile: Die kritischen Verbindungen zum Tuner, zur Steuereinrichtung und zum Scartstecker, zur Vertikal-Endstufe, zur Ton-Endstufe und zur Horizontal-Endstufe können annähernd gleich lang ausgeführt werden. Bei einem vertikal stehenden Modul müßten dagegen diese Leitungen zumindest teilweise wesentlich länger ausgeführt werden, wodurch Probleme bei der Einstrahlung entstehen können. Eine Abschirmung des senkrecht stehenden Moduls könnte somit notwendig werden, wodurch ein zusätzlicher Herstellungsaufwand verbunden ist. Das Problem der längeren Leitungen wäre damit nicht gelöst. Bei dem erfindungsgemäßen Chassis wird dagegen durch die darunter verlaufende Massefläche eine so gute Abschirmung erreicht, daß nur in Ausnahmefällen eine zusätzliche Abschirmung auf der Oberseite der Zentralplatine erforderlich ist.

Ein weiterer Vorteil des erfindungsgemäßen Chassis liegt darin, daß die Gerätehersteller durch das erfindungsgemäße Chassis dadurch flexibler und wirtschaftlich unabhängiger sind, daß sie beispielsweise eine gleich große pinkomplatible Zentralplatine mit jedoch einer anderen IC-Bestückung entwickeln können, z.B. mit einem separaten Bild-ZF-IC, der die Funktion Quasi-/Parallelton beinhaltet und damit ein qualitativ hochwertiges Stereogerät ermöglicht. Für den Fernsehgerätehersteller ist es aber auch von Vorteil, daß er die Zentralplatine genau auf die Bedürfnisse seines Marktes hin konzipieren kann.

Zusammenfassend bietet das erfindungsgemäße Chassis folgende Vorteile:
- Kostengünstiger Einsatz eines einzigen integrierten Schaltkreises für die zentrale Signalverarbeitung des Fernsehsignalempfangsgerätes;
- nur eine geringe Fläche, nämlich die der Zentralplatine, muß in SMD-Technik ausgeführt werden;
- der Gerätehersteller ist wirtschaftlich unabhängig. Er kann verschiedene, je nach Bedarf notwendige Zentralplatinen mit einem einzigen integrierten Schaltkreis oder mehreren integrierten Schaltkreisen verschiedener Hersteller entwickeln oder einsetzen;
- die technische und wirtschaftliche Flexibilität ist damit ebenso groß wie bei der bisherigen Modultechnik; und
- eine gute Abschirmwirkung durch die unterhalb der Zentralplatine vorgesehene Kupferkaschierung der Hauptplatine.

Die Erfindung wird im folgenden anhand von drei Figuren naher erläutert. Es zeigen
- FIG 1: eine Draufsicht auf ein erfindungsgemäßes Chassis in schematischer Darstellung,
- FIG 2: eine Seitenansicht von Zentralplatine und Hauptplatine sowie
- FIG 3: eine Detaildarstellung, wie die Zentralplatine auf der Hauptplatine zu montieren ist.

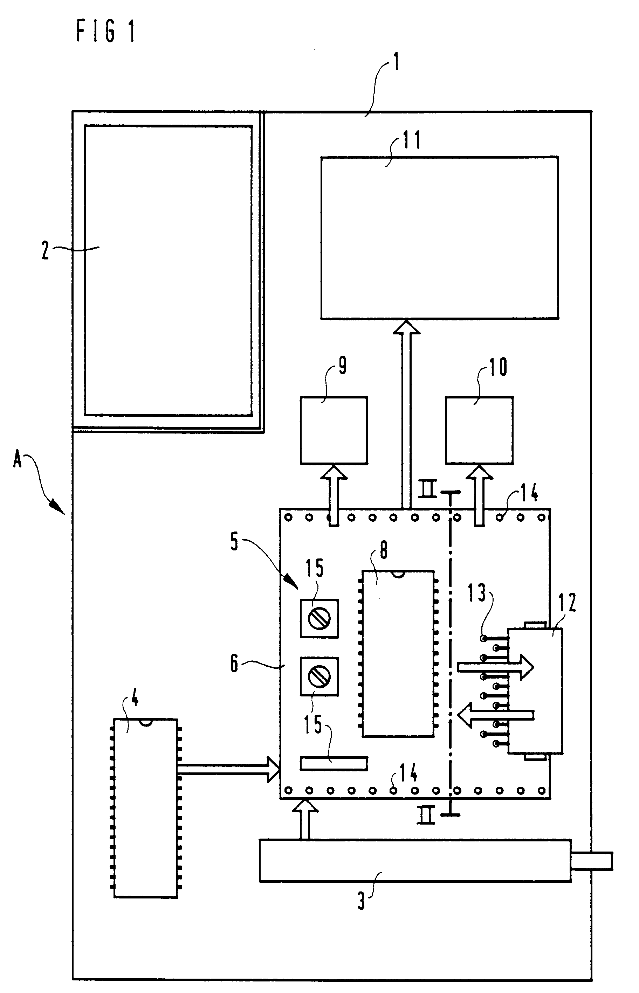

FIG 1 zeigt ein Chassis für ein Farbfernsehgerät, das eine Hauptplatine 1 aufweist, auf der ein Netzteil 2, ein Tuner 3, eine Steuereinrichtung 4 in Form eines Mikrocontrollers als integrierte Schaltungsanordnung sowie eine die zentrale Signalverarbeitung des Fernsehers übernehmende Einrichtung 5 angeordnet ist. Darüberhinaus ist auf der Hauptplatine 1 eine Vertikalendstufe 9, eine Horizontalendstufe 11 sowie eine Tonendstufe 10 angeordnet, die über Signalleitungen - der Einfachheit halber durch Pfeile angedeutet - Ausgangssignale von der zentralen Signalverarbeitungseinrichtung erhalten. Diese die zentrale Signalverarbeitung des Fernsehers übernehmende Einrichtung 5 erhält auch - ebenfalls durch Pfeile schematisch dargestellt - sowohl vom Tuner 3 ein Nutzsignal sowie von dem Mikrocontroller 4 Steuersignale zur weiteren Verarbeitung.

Diese die zentrale Signalverarbeitung des Fernsehers übernehmende Einrichtung 5 ist auf einer Zentralplatine 6 angeordnet, die oberhalb der Hauptplatine 1 parallel zu dieser montiert ist und über Anschlußkontakte 14 mit dieser in elektrischer Verbindung steht.

Auf dieser Zentralplatine 6 ist beispielsweise eine integrierte Schaltungsanordnung 8 vorgesehen, die neben weiteren Bauelementen die zentrale Signalverarbeitung des Fernsehgerätes, wie z.B. die Stufen Bild-ZF, Ton-ZF, Farbdecodierung, RGB-Videoprozessor, H+V-Synchronisation sowie Scart-Schalter übernimmt. Aus Gründen der besseren Einstrahlungsfestigkeit sind die auf der Zentralplatine 6 angeordneten Bauelemente in SMD-Technik realisiert. Auf dieser Zentralplatine 6 befindet sich zusätzlich eine Scart-Buchse 12, die über Klemmen 13 mit der Zentralplatine 6 und damit der die zentrale Signalverarbeitung bildenden Einrichtung 5 in Verbindung steht.

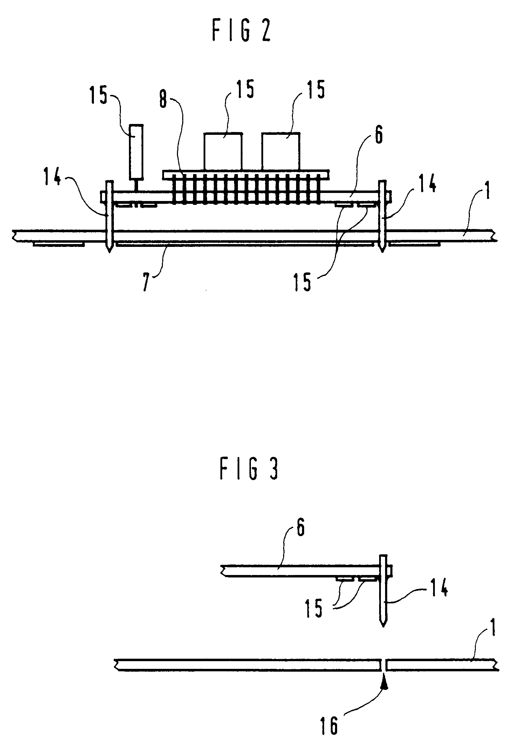

In FIG 2 ist eine Schnittdarstellung entlang der in FIG 1 dargestellten Linie II-II gezeigt. Hier ist deutlich das übereinander parallele Anordnen von Zentralplatine 6 und Hauptplatine 1 zu erkennen. Die Zentralplatine 6 steht über die Kontaktstifte 14, die sich in diesem Ausführungsbeispiel an sich zwei gegenüberliegenden Stirnseiten der Zentralplatine 6 befinden, mit Leiterbahnen der Hauptplatine 1 in Verbindung. Diese Kontaktstifte 14 dienen zugleich auch als Abstandshalterungen. Für die Abschirmung der Zentralplatine 6 ist auf der Hauptplatine 1 unterhalb der Zentralplatine, in diesem Fall auf der der Zentralplatine 6 entgegenstehenden Seite, eine Metallisierung aufgebracht. Vorzugsweise ist die Hauptplatine an dieser Stelle durchgehend kupferkaschiert und fungiert als Abschirmung und bewirkt eine optimale Masseverbindung. Diese als Abschirmung 7 vorgesehene Kupferkaschierung der Unterseite der Hauptplatine 1 ist natürlich so gestaltet, daß die Kontaktierung der Kontaktstifte 14 der Zentralplatine 6 nicht kurzgeschlossen werden.

In FIG 3 ist dargestellt, wie die Zentralplatine 6 mit ihren Kontaktstiften 14 in dafür vorgesehene Ausnehmungen der Hauptplatine plaziert werden. Die Kontaktstifte 14 können dabei entweder als Löt- oder Steckverbindung mit der Hauptplatine 1 in Kontakt gebracht werden. Dies kann vorzugsweise durch ein Schwalllöten zusammen mit allen anderen Bauteilen auf der Hauptplatine erfolgen.

## Patentansprüche

1. Chassis für ein Fernsehsignalempfangsgerät mit mindestens einer auf einer Hauptplatine (1) angeordneten Stromversorgungseinrichtung (2), einem Tuner (3), einer Steuereinrichtung (4) sowie einer die zentrale Signalverarbeitung des Fernsehsignalempfangsgerätes übernehmenden Einrichtung (5)
**dadurch gekennzeichnet,**
daß die die zentrale Signalverarbeitung des Fernsehers übernehmende Einrichtung (5) auf einer in ihrer Fläche im Vergleich zur Hauptplatine (1) kleineren Zentralplatine (6) angeordnet ist, daß die Zentralplatine (6) parallel zur Hauptplatine (1) angeordnet ist und daß der Bereich der Hauptplatine (1), der sich unterhalb der Zentralplatine (6) befindet, mit einer Abschirmung (7) versehen ist.

2. Chassis nach Anspruch 1,
**dadurch gekennzeichnet,**
daß für die Abschirmung (7) die Hauptplatine (1) unterhalb der Zentralplatine (6) mindestens annähernd durchgehend mit einer Metallisierung versehen ist.

3. Chassis nach Anspruch 1 oder 2,
**dadurch gekennzeichnet,**
daß die Zentralplatine (6) in SMD-(Surface Mounted Device)-Technik ausgeführt ist.

4. Chassis nach einem der Ansprüche 1 bis 4,
**dadurch gekennzeichnet,**
daß auf der Zentralplatine (6) lediglich eine einzige für die zentrale Signalverarbietung des Fernsehsignalempfangsgeräts vorgesehene integrierte Schaltung (8) angeordnet ist.

5. Chassis nach einem der Ansprüche 1 bis 4,
**dadurch gekennzeichnet,**
daß das Chassis (A) für einen Fernseher vorgesehen ist und die Hauptplatine (1) zusätzlich eine Vertikalendstufe (9), eine Horizontalendstufe (11) sowie eine Tonendstufe (10) aufweist.

6. Chassis nach einem der Ansprüche 1 bis 5,
**dadurch gekennzeichnet,**
daß auf der Zentralplatine (6) zusätzlich eine Scart-Buchse (12) angeordnet ist, die mit Klemmen (13) der Einrichtung (5) verbunden ist.
